# FASCICULE DE BREVET EUROPEEN

(11) **EP 1 362 376 B1**
(45) Date de publication et mention de la délivrance du brevet: **08.03.2006**
(21) Numéro de dépôt: 01990617.1
(22) Date de dépôt: 28.12.2001
(51) Int. Cl.: H01L 29/747

(54) **COMMUTATEUR ELECTRONIQUE BIDIRECTIONNEL BISTABLE A COMMANDE PAR IMPULSIONS**
BISTABILER ELEKTRONISCHER ZWEIRICHTUNGSSCHALTER MIT IMPULSSTEUERUNG
PULSED BISTABLE BIDIRECTIONAL ELECTRONIC SWITCH

(30) Priorité: 29.12.2000 FR 0017295
(43) Date de publication de la demande: 19.11.2003
(73) Titulaire: STMicroelectronics S.A., 92120 Montrouge (FR)
(72) Inventeur: GIMONET, Sophie, F-37100 Tours (FR); DUCLOS, Franck, F-37000 Tours (FR)
(74) Mandataire: de Beaumont, Michel
(86) Numéro de dépôt international: PCT/FR2001/004223
(87) Numéro de publication internationale: WO 2002/054496

(56) Documents cités:
- EP-A- 0 164 106
- EP-A- 0 315 273
- EP-A- 0 348 128
- EP-A- 0 396 104
- US-A- 5 345 094
- US-A- 5 838 110
- US-A- 6 075 277
- PATENT ABSTRACTS OF JAPAN vol. 2000, no. 02, 29 février 2000 (2000-02-29) & JP 11 307277 A (MATSUSHITA ELECTRIC WORKS LTD), 5 novembre 1999 (1999-11-05)

## Description

La présente invention concerne un commutateur bidirectionnel bistable, c'est-à-dire un commutateur susceptible d'être rendu conducteur pendant plusieurs alternances d'une tension alternative qui lui est appliquée à la suite d'une impulsion de commande unique. Ce commutateur bistable peut ensuite être ouvert par application d'une nouvelle impulsion et rester à l'état ouvert jusqu'à réception d'une nouvelle impulsion de fermeture.

Une première catégorie de commutateurs bidirectionnels est constituée de commutateurs de type triac ou autres commutateurs bidirectionnels correspondant à des associations de thyristors. Une caractéristique commune de ces composants est qu'ils sont mis en conduction au cours d'une alternance donnée par une impulsion puis qu'ils s'ouvrent automatiquement quand le courant qui les traverse devient inférieur à un seuil déterminé, généralement appelé courant de maintien i_{H}. Ensuite, pour remettre en conduction de tels commutateurs bidirectionnels, il faut réappliquer une impulsion à chaque alternance pendant laquelle on veut que le composant soit mis à l'état passant. Ainsi, ces commutateurs ne sont pas bistables.

Une autre catégorie de commutateurs bidirectionnels est constituée de composants de type transistor MOS ou bipolaire qui deviennent passants lorsqu'un signal est appliqué à leur borne de commande mais pour lesquels il faut maintenir en permanence cet ordre de commande pour que le composant reste passant. De tels composants de type transistor ne sont pas commandables par impulsions.

Dans l'art antérieur, on a prévu des circuits associant des composants semiconducteurs et des composants passifs en des circuits permettant d'obtenir un commutateur bidirectionnel bistable à commande par impulsions. Néanmoins, ces circuits sont relativement complexes et nécessitent généralement l'association de plusieurs composants semiconducteurs et de plusieurs composants passifs.

Des commutateurs bedirectionnels verticaux sont connus de US-6, 075, 277.

La présente invention vise la réalisation sous forme essentiellement monolithique d'un commutateur bidirectionnel bistable à commande par impulsions.

Pour atteindre cet objet, la présente invention prévoit un commutateur bidirectionnel de type bistable à commande par impulsions comprenant :
- un circuit semiconducteur monolithique formé à partir d'un substrat faiblement dopé de type N dont la face arrière est revêtue d'une métallisation connectée à un potentiel de référence, comprenant :
   - une structure de commutateur bidirectionnel vertical munie d'une première borne de gâchette, et dont l'électrode principale du côté de la face avant est connectée à une charge et à une alimentation alternative ;
   - une structure de thyristor horizontal comprenant une couche supérieure du commutateur bidirectionnel vertical, le substrat, une première région de type P formée dans le substrat, et une deuxième région de type N formée dans la première région ;
   - une deuxième borne de gâchette reliée à l'une des première et deuxième régions, l'autre des première et deuxième régions étant reliée au potentiel de référence ;
- un condensateur connecté à la première borne de gâchette et à l'alimentation alternative ; et
- un interrupteur de mise en court-circuit du condensateur.

Selon un mode de réalisation de la présente invention, le circuit semiconducteur monolithique comprend :
un substrat de type N ;
   - du côté de la face avant :
      une troisième région de type P d'anode d'un thyristor vertical, cette troisième région contenant une quatrième région de type N de cathode d'un deuxième thyristor vertical, et une cinquième région de type N constituant une région de gâchette ;
   - du côté de la face arrière :
      une couche de type P ;
      dans cette couche de type P, des sixièmes régions de type N partout sauf à l'emplacement de l'anode du deuxième thyristor constituant la structure de commutateur bidirectionnel vertical.

Selon un mode de réalisation de la présente invention, la première région de la structure de thyristor horizontal s'étend jusqu'à un mur d'isolement reliant cette région à la face arrière.

Selon un mode de réalisation de la présente invention, le commutateur électronique comprend en outre de façon monolithique l'interrupteur de mise en court-circuit du condensateur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe schématique d'un premier mode de réalisation d'un commutateur bidirectionnel bistable selon la présente invention ; et
la figure 2 est une vue en coupe schématique d'un deuxième mode de réalisation d'un commutateur bidirectionnel bistable selon la présente invention.

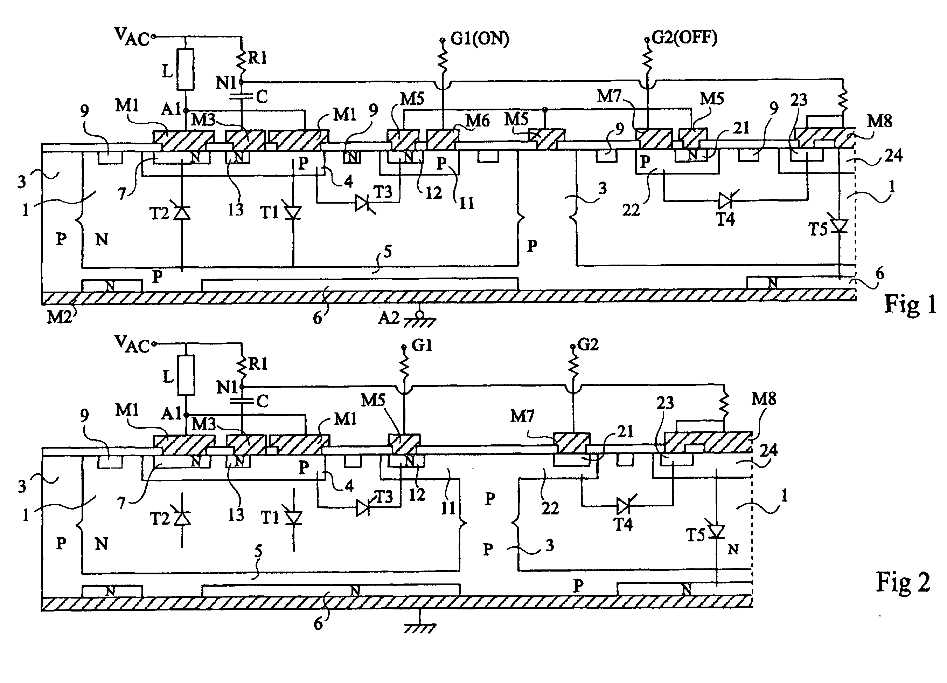

Comme l'illustre la figure 1, le commutateur bidirectionnel bistable selon la présente invention comprend essentiellement un circuit ou composant semiconducteur monolithique formé à partir d'un substrat semiconducteur 1 de type N et un condensateur C.

Le composant semiconducteur monolithique comprend dans sa partie gauche, entourée par un mur d'isolement 3 de type P, une structure de commutateur bidirectionnel vertical et sa structure de mise en conduction. Dans la partie droite de la figure se trouve un ensemble destiné à assurer l'ouverture du commutateur.

La partie gauche de la figure 1 comprend une structure de composant bidirectionnel vertical associant deux thyristors en anti-parallèle T1 et T2. Le thyristor T1 comprend, de la face avant à la face arrière et de son anode à sa cathode, une région 4 de type P, le substrat 1, une couche 5 de type P et une région 6 de type N. Le thyristor T2 comprend, de la face avant à la face arrière et de sa cathode à son anode, une région 7 de type N, une portion de la région 4 de type P, le substrat 1 de type N et une portion de la couche 5 de type P. Bien que cela n'apparaisse pas dans la figure, dans le cas d'un composant de moyenne puissance, c'est ce commutateur bidirectionnel qui occupe la plus grande partie de la surface du composant, et qui est destiné à laisser passer un courant important. Les autres éléments de la figure sont destinés à assurer la fermeture et l'ouverture de ce commutateur.

La couche 5 de type P susmentionnée s'étend sur toute la surface arrière ou inférieure du composant. La région 6 de type N s'étend du côté de la face arrière sur toute la partie gauche du composant, à l'exception de l'emplacement où l'on veut avoir la partie d'anode de face inférieure du thyristor T2. On a également représenté des régions 9 de type N du côté de la face supérieure, de part et d'autre de chaque caisson de type P, pour constituer de façon classique des zones d'arrêt de canal. Ces zones d'arrêt de canal sont couramment revêtues de métallisations non représentées.

Par souci de simplicité, on appellera triac TR l'ensemble des deux thyristors T1, T2 susmentionnés constituant la structure bidirectionnelle verticale.

La structure de la partie gauche de la figure 1 comprend également un thyristor horizontal T3 qui comprend, de son anode à sa cathode, la région 4 de type P, le substrat 1, une région 11 de type P formée du côté de la face supérieure et une région 12 de type N formée dans la région 11.

La région 4 de type P contient en outre une autre région de type N 13 constituant la région de gâchette du triac.

Une métallisation M1 recouvre la région d'anode 4 du thyristor T1 et la région de cathode 7 du thyristor T2. Une métallisation M2 recouvre toute la face arrière du composant. La métallisation M2, qui constitue une borne A2 du triac, est reliée à un potentiel de référence, couramment la masse. La métallisation M1 constitue la borne A1 du triac et est reliée à une tension alternative d'alimentation VAC par l'intermédiaire d'une charge L dans laquelle on veut laisser passer ou non du courant. La région de gâchette 13 de type N formée dans la région 4 de type P est revêtue d'une métallisation M3 connectée à une première borne d'un condensateur C dont la deuxième borne est reliée à un noeud N1 du circuit qui est connecté à la tension alternative d'alimentation VAC par l'intermédiaire d'une résistance R1. La cathode 12 du thyristor latéral T3 est revêtue d'une métallisation M5 qui est connectée à une autre métallisation M5 formée sur la face supérieure du mur d'isolement 3. La région de gâchette 11 du thyristor latéral T3 est revêtue d'une métallisation M6 reliée à une borne de gâchette G1.

Avant d'expliquer le fonctionnement du dispositif de la figure 1, on rappellera les désignations classiques des modes d'amorçage d'un commutateur bidirectionnel, par exemple un triac. On dit qu'un triac fonctionne dans l'un ou l'autre de quatre quadrants Q1, Q2, Q3, Q4. On choisit une borne de référence, généralement reliée à la masse, et on considère les polarités de la tension sur l'autre borne, ici la borne A1, et de la tension de gâchette sur la borne G1. On dit que le triac est amorcé dans le premier quadrant Q1 quand les tensions sur les bornes A1 et G1 sont positives par rapport à la borne A2. On est dans le deuxième quadrant Q2 quand la tension sur la borne A2 est positive et que la tension sur la borne G1 est négative. On est dans le troisième quadrant Q3 quand les tensions sur les bornes A1 et G1 sont négatives. Enfin, on est dans le quatrième quadrant Q4 quand la tension sur la borne A1 est négative et que la tension sur la borne G1 est positive.

La structure représentée en figure 1 fonctionne dans le premier quadrant. Ceci signifie qu'elle peut être mise en conduction quand la tension VAC est positive par rapport à la borne A2 et que l'on applique une tension positive sur la gâchette G1. Pour être sûr de déclencher le composant quel que soit l'instant auquel on applique l'impulsion de commande, on veillera à ce que la durée de l'impulsion de commande soit plus longue que la durée d'une alternance de la tension alternative, par exemple 10 ms si cette tension alternative est à 50 Hz.

Quand l'impulsion de gâchette est appliquée, le thyristor latéral T3 est rendu passant par l'impulsion de gâchette sur la borne G1. Un courant s'établit de la borne A1 vers la borne A2, en passant par le thyristor T3 et par le mur d'isolement 3. Une fois la conduction du thyristor T3 établie, des porteurs sont injectés dans le substrat 1 et provoquent la mise en conduction du thyristor vertical convenablement polarisé à ce moment, c'est-à-dire le thyristor T1. Pendant la conduction du thyristor vertical T1, le condensateur C se charge avec une tension positive sur le noeud N1.

Au moment où le thyristor T1 s'ouvre en raison du passage par zéro du courant qui le traverse, le condensateur C amène un courant à circuler dans la gâchette du thyristor vertical T2. On notera que la métallisation de gâchette M3 recouvre non seulement la région 13 de type N mais aussi une région voisine du caisson 4 de type P. Pendant que le thyristor T2 est passant, le condensateur C se charge avec une polarité inverse de la précédente, c'est-à-dire avec une tension négative sur le noeud N1. Lors de l'alternance suivante, le thyristor T1 sera mis en conduction à son tour par un courant de gâchette résultant de la décharge du condensateur C.

Ainsi, une fois l'amorçage initial réalisé par le signal sur la gâchette G1 du thyristor auxiliaire T3, le triac constitué des thyristors T1 et T2 se réamorce automatiquement à chaque alternance sous l'effet de la décharge du condensateur C dans sa gâchette.

Une fois le composant mis en conduction, pour arrêter son fonctionnement, il faut décharger le condensateur C. Pour cela, on pourra prévoir tout commutateur de mise en court-circuit du condensateur C. La figure 1 représente dans sa partie droite un exemple de réalisation intégrée d'un tel commutateur constitué d'un thyristor horizontal T4 et d'un thyristor vertical T5. La structure comprend une région N 21 formée dans un caisson P 22 et une région N 23 formée dans un caisson P 24. La région 21 est recouverte de la métallisation M5 susmentionnée. La région 22 est recouverte d'une métallisation M7 reliée à une borne de gâchette G2. Les régions 23 et 24 sont revêtues d'une métallisation M8 reliée au noeud N1. On a ainsi obtenu un thyristor latéral PNPN T4 comprenant les régions 22-1-24-23 et un thyristor vertical PNPN T5 comprenant les régions 24-1-5-6. La région 6 de type N s'étend sous la structure de thyristor vertical du côté de la face arrière, et est formée en même temps que les régions 6 de type N existant dans la partie gauche de la figure.

Pour provoquer l'ouverture, il faut appliquer sur la borne G2 une tension positive pendant une alternance positive. Ceci déclenche le thyristor latéral T4 puis le thyristor vertical T5, ce dernier assurant la décharge du condensateur C en reliant le noeud N1 à l'électrode A2 mise au potentiel de la masse.

La structure selon la présente invention est susceptible de nombreuses variantes et modifications permettant notamment d'obtenir des déclenchements dans divers quadrants.

La figure 2 représente un exemple d'une telle variante capable de fonctionner à la fermeture dans le quadrant Q2 ou Q3 (et non dans le seul quadrant Q1 comme cela était le cas du mode de réalisation de la figure 1).

En figure 2, de mêmes éléments sont désignés par les mêmes références qu'en figure 1. La structure du triac principal comprenant les thyristors T2 et T1 est sensiblement identique à celle de la figure 1. Toutefois, dans ce cas, le thyristor latéral de fermeture de la structure a sa région P 11 qui se prolonge jusqu'au caisson 3 et qui est donc en continuité avec celui-ci. On pourra voir que cette structure peut s'amorcer quand une impulsion négative est appliquée sur la borne G1 qui dans ce cas n'est pas une borne de gâchette mais une borne de cathode du thyristor T3. La gâchette, qui correspond à la région 11 est reliée à la masse par le mur d'isolement 3. Un courant de gâchette circule donc quand la borne G1 est à un potentiel suffisamment inférieur au potentiel de la masse pour rendre passante la jonction entre les régions 11 et 12. Quand le thyristor T3 est convenablement polarisé (quadrant Q2), le thyristor T3 s'amorce et provoque la mise en conduction du thyristor T1. Quand le thyristor T3 est polarisé en inverse, la jonction 11-12 devient passante, il se produit également une injection de porteurs dans le substrat 1, ce qui provoque directement la mise en conduction du thyristor T2.

Dans la structure d'ouverture disposée à droite de la figure, la région 22 est en continuité avec le mur d'isolement 3.

La présente invention est susceptible de nombreuses autres variantes et modifications qui apparaîtront à l'homme de l'art, notamment en ce qui concerne des modifications du composant de puissance vertical bidirectionnel principal et des variantes de réalisation des éléments auxiliaires d'amorçage et d'extinction. De plus la structure peut être réalisée en inversant tous les types de conductivité.

Le composant bidirectionnel bistable selon la présente invention pourrait être réalisé isolément dans une plaquette de silicium ou faire partie d'une structure d'ensemble incorporant d'autres composants du même type, comme cela est décrit par exemple dans le brevet américain 6075277 (B2578).

## Revendications

1. Commutateur électronique bidirectionnel de type bistable à commande par impulsions comprenant :
- un circuit semiconducteur monolithique formé à partir d'un substrat (1) faiblement dopé de type N dont la face arrière (A2) est revêtue d'une métallisation connectée à un potentiel de référence, comprenant :
. une structure de commutateur bidirectionnel vertical (T1, T2) munie d'une première borne de gâchette (M3), dont l'électrode principale (A1) du côté de la face avant est connectée à une charge et à une alimentation alternative ;
. une structure de thyristor horizontal (T3) comprenant une couche supérieure (4) du commutateur bidirectionnel vertical, le substrat (1), une première région de type P (11) formée dans le substrat, et une deuxième région de type N (12) formée dans la première région ;
. une deuxième borne de gâchette (G1) reliée à l'une des première et deuxième régions, l'autre des première et deuxième régions étant reliée au potentiel de référence ;
- un condensateur (C) connecté à la première borne de gâchette (M3) et à l'alimentation alternative (VAC) ; et
- un interrupteur de mise en court-circuit du condensateur.

2. Commutateur électronique selon la revendication 1, **caractérisé en ce que** le circuit semiconducteur monolithique comprend :
un substrat (1) de type N ;
- du côté de la face avant :
une troisième région (4) de type P d'anode d'un thyristor vertical (T1), cette troisième région contenant une quatrième région de type N (7) de cathode d'un deuxième thyristor vertical (T2), et une cinquième région (13) de type N constituant une région de gâchette ;
- du côté de la face arrière :
une couche (5) de type P ;
dans cette couche de type P, des sixièmes régions (6) de type N partout sauf à l'emplacement de l'anode du deuxième thyristor constituant la structure de commutateur bidirectionnel vertical.

3. Commutateur électronique bidirectionnel de type bistable à commande par impulsions comprenant :
- un circuit semiconducteur monolithique formé à partir d'un substrat (1) faiblement dopé de type P dont la face arrière (A2) est revêtue d'une métallisation connectée à un potentiel de référence, comprenant :
. une structure de commutateur bidirectionnel vertical (T1, T2) munie d'une première borne de gâchette (M3), dont l'électrode principale (A1) du côté de la face avant est connectée à une charge et à une alimentation alternative ;
. une structure de thyristor horizontal (T3) comprenant une couche supérieure (4) du commutateur bidirectionnel vertical, le substrat (1), une première région de type N (11) formée dans le substrat, et une deuxième région de type P (12) formée dans la première région ;
. une deuxième borne de gâchette (G1) reliée à l'une des première et deuxième régions, l'autre des première et deuxième régions étant reliée au potentiel de référence ;
- un condensateur (C) connecté à la première borne de gâchette (M3) et à l'alimentation alternative (VAC) ; et
- un interrupteur de mise en court-circuit du condensateur.

4. Commutateur électronique selon la revendication 3, **caractérisé en ce que** le circuit semiconducteur monolithique comprend :
un substrat (1) de type P ;
- du côté de la face avant :
une troisième région (4) de type N de cathode d'un thyristor vertical (T1) cette troisième région contenant une quatrième région de type P (7) d'anode d'un deuxième thyristor vertical (T2), et une cinquième région (13) de type P constituant une région de gâchette ;
- du côté de la face arrière :
une couche (5) de type N ;
dans cette couche de type N, des sixièmes régions (6) de type P partout sauf à l'emplacement de la cathode du deuxième thyristor constituant la structure de commutateur bidirectionnel vertical.

5. Commutateur électronique selon la revendication 1 ou 3, **caractérisé en ce que** la première région (11) de la structure de thyristor horizontal s'étend jusqu'à un mur d'isolement (3) reliant cette région à la face arrière.

6. Commutateur électronique selon la revendication 1 ou 3, **caractérisé en ce qu'**il comprend en outre de façon monolithique l'interrupteur de mise en court-circuit du condensateur.

## Claims

1. A bidirectional switch of pulse-controlled bistable type, including:
a monolithic semiconductor circuit formed from a lightly-doped N-type substrate (1) having its rear surface (A2) coated with a metallization connected to a reference voltage, including:
- a vertical bidirectional switch structure (T1, T2) provided with a first gate terminal (M3), and having its main electrode (A1) on the front surface side connected to a load and to an A.C. power supply;
- a horizontal thyristor structure (T3) including an upper layer (4) of the vertical bidirectional switch, the substrate (1), a first P-type region (11) formed in the substrate, and a second N-type region (12) formed in the first region;
- a second gate terminal (G1) connected to one of the first and second regions, the other one of the first and second regions being connected to the reference voltage;
a capacitor (C) connected to the first gate terminal (M3) and to the A.C. power supply (VAC); and
a switch for short-circuiting the capacitor.

2. The electronic switch of claim 1, wherein the monolithic semiconductor circuit includes:
an N-type substrate (1);
- on the front surface side:
a third P-type anode region (4) of a vertical thyristor (T1), this third region containing a fourth N-type cathode region (7) of a second vertical thyristor (T2), and a fifth N-type region (13) forming a gate region;
- on the rear surface side:
a P-type layer (5);
in this P-type layer, sixth N-type regions (6) everywhere except at the location of the anode of the second thyristor forming the vertical bidirectional switch structure.

3. A bidirectional switch of pulse-controlled bistable type, including:
a monolithic semiconductor circuit formed from a lightly-doped P-type substrate (1) having its rear surface (A2) coated with a metallization connected to a reference voltage, including:
- a vertical bidirectional switch structure (T1, T2) provided with a first gate terminal (M3), and having a main electrode (A1) on a front surface side connected to a load and to an A.C. power supply;
- a horizontal thyristor structure (T3) including an upper layer (4) of the vertical bidirectional switch, the substrate (1), a first N-type region (11) formed in the substrate, and a second P-type region (12) formed in the first region;
- a second gate terminal (G1) connected to one of the first and second regions, another of the first and second regions being connected to the reference voltage;
a capacitor (C) connected to the first gate terminal (M3) and to the A.C. power supply (VAC); and
a switch for short-circuiting the capacitor.

4. The electronic switch of claim 3, wherein the monolithic semiconductor circuit includes:
a P-type substrate (1);
- on the front surface side:
a third N-type anode region (4) of a vertical thyristor (T1), this third region containing a fourth P-type cathode region (7) of a second vertical thyristor (T2), and a fifth P-type region (13) forming a gate region;
- on the rear surface side:
an N-type layer (5);
in this N-type layer, sixth P-type regions (6) everywhere except at a location of the anode of the second thyristor forming the vertical bidirectional switch structure.

5. The electronic switch of claim 1 or 3, wherein the first region (11) of the horizontal switch structure extends to reach an isolating wall (3) connecting this region to the rear surface.

6. The electronic switch of claim 1 or 3, further monolithically including the switch for short-circuiting the capacitor.

## Patentansprüche

1. Ein bidirektionaler Schalter des impulsgesteuerten bistabilen Typs, der Folgendes umfasst:
eine monolithische Halbleiterschaltung, die auf einem leicht dotierten Substrat (1) des N-Typs ausgebildet ist, dessen Rückseite (A2) mit einer Metallisierung beschichtet ist, die mit einer Referenzspannung verbunden ist, wobei die Schaltung Folgendes aufweist:
eine vertikale bidirektionale Schalterstruktur (T1, T2), die mit einem ersten Gateanschluss (M3) versehen ist und dessen Hauptelektrode (A1) auf der Vorderseite mit einer Last und einer Wechselspannung bzw, A.C. Energieversorgung verbunden ist;
eine horizontale Thyristorstruktur (T3), die eine obere Lage (4) des vertikalen bidirektionalen Schalters umfasst, wobei das Substrat (1) einen ersten Bereich (11) des P-Typs in dem Substrat ausgebildet besitzt und einen zweiten Bereich (12) des N-Typs, der in dem ersten Bereich ausgebildet ist;
ein zweiter Gateanschluss (G1), der mit einem der ersten und zweiten Bereiche verbunden ist, wobei der andere der ersten und zweiten Bereiche mit der Bezugsspannung verbunden ist;
ein Kondensator (C), der mit dem ersten Gateanschluss (M3) und der A.C. Energieversorgung (VAC) verbunden ist; und
ein Schalter zum Kurzschließen des Kondensators.

2. Elektronischer Schalter nach Anspruch 1, wobei die monolithische Halbleiterschaltung Folgendes aufweist:
ein N-Typ-Substrat (1);
auf der Vorderseite:
einen dritten Anodenbereich (4) des P-Typs eines vertikalen Thyristors (T1), wobei dieser dritte Bereich einen vierten Katodenbereich (7) des N-Typs eines zweiten vertikalen Thyristors (T2) enthält und einen fünften Bereich (13) des N-Typs, der einen Gatebereich bildet;
auf der Rückseite:
eine Schicht (5) des P-Typs;
wobei in dieser Schicht des P-Typs sechs Bereiche (6) des N-Typs überall vorgesehen sind mit Ausnahme des Ortes der Anode des zweiten Thyristors, der die vertikale bidirektionale Schalterstruktur bildet.

3. Bidirektionaler Schalter des impulsgesteuerten bistabilen Typs, der Folgendes umfasst:
eine monolithische Halbleiterschaltung, die aus einem leicht dotierten Substrat (1) des P-Typs gebildet ist, dessen Rückseite (A2) mit einer Metallisierung beschichtet ist, die mit einer Referenzspannung verbunden ist, die Folgendes aufweist:
eine vertikale bidirektionale Schalterstruktur (T1, T2), die mit einem ersten Gateanschluss (M3) versehen ist, und eine Hauptelektrode (A1) auf einer Vorderseite aufweist, die mit einer Last und mit einer Wechselspannungs- bzw. A.C. Energieversorgung verbunden ist;
eine horizontale Thyristorstruktur (T3), die eine obere Schicht (4) des vertikalen bidirektionen Schalters umfasst, wobei das Substrat (1) einen ersten Bereich (11) des N-Typs in dem Substrat ausgebildet besitzt, und einen zweiten Bereich (12) des P-Typs, der in dem ersten Bereich ausgebildet ist;
ein zweiter Gateanschluss (G1), der mit einem der ersten und zweiten Bereiche verbunden ist, wobei der andere der ersten und zweiten Bereiche mit der Bezugsspannung verbunden ist;
ein Kondensator (C), der mit dem ersten Gateanschluss (M3) und der A.C. Energieversorgung (VAC) verbunden ist; und
ein Schalter zum Kurzschließen des Kondensators.

4. Elektronischer Schalter nach Anspruch 3, wobei die monolithische Halbleiterschaltung Folgendes aufweist:
ein P-Typ-Substrat (1);
auf dessen Vorderseite ein dritter Anodenbereich (4) des N-Typs eines vertikalen Thyristors (T1) vorgesehen ist, wobei dieser dritte Bereich einen vierten Katodenbereich (7) des P-Typs eines zweiten vertikalen Thyristors (T2) enthält und einen fünften Bereich (13) des P-Typs, der einen Gatebereich bildet; und
auf dessen Rückseite eine N-Typschicht (5) vorgesehen ist, wobei in dieser N-Typschicht sechs Bereiche des P-Typs (6) überall vorgesehen sind, mit Ausnahme des Orts der Anode des zweiten Thyristors, der die vertikale bidirektionale Schalterstruktur bildet.

5. Elektronischer Schalter nach Anspruch 1 oder 3, wobei der erste Bereich (11) der horizontalen Schalterstruktur sich derart erstreckt, dass sie eine Isolierwand (3) erreicht, die diesen Bereich mit der Rückseite verbindet.

6. Elektronischer Schalter nach Anspruch 1 oder 3, der ferner monolithisch den Schalter zum Kurzschließen des Kondensators umfasst.
